(19) Europäisches Patentamt
European Patent Office
Office européen des brevets

(11) **EP 4 603 854 B1**

(12) **EUROPEAN PATENT SPECIFICATION**

(45) Date of publication and mention
of the grant of the patent:
**29.07.2026 Bulletin 2026/31**

(21) Application number: **25158045.2**

(22) Date of filing: **14.02.2025**

(51) International Patent Classification (IPC):
**G01R 31/389** (2019.01)    **G01R 31/392** (2019.01)
**H01M 10/48** (2006.01)

(52) Cooperative Patent Classification (CPC):
**G01R 31/392; G01R 31/389; H01M 10/48;**
Y02E 60/10

(54) **BATTERY INFORMATION GENERATING APPARATUS AND METHOD**

VORRICHTUNG UND VERFAHREN ZUR ERZEUGUNG VON BATTERIEINFORMATIONEN

APPAREIL ET PROCÉDÉ DE GÉNÉRATION D'INFORMATIONS DE BATTERIE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **16.02.2024 KR 20240022912**

(43) Date of publication of application:
**20.08.2025 Bulletin 2025/34**

(73) Proprietor: **LG Energy Solution, Ltd.
Seoul 07335 (KR)**

(72) Inventors:
• **CHA, A-Ming**
**34122 Daejeon (KR)**
• **SUN, Kyung-Eun**
**34122 Daejeon (KR)**
• **BAE, Yoon-Jung**
**34122 Daejeon (KR)**

(74) Representative: **Goddar, Heinz J.
Boehmert & Boehmert
Anwaltspartnerschaft mbB
Pettenkoferstrasse 22
80336 München (DE)**

(56) References cited:
**EP-A1- 4 425 646        KR-B1- 102 600 139
US-A1- 2012 169 288**

**Description**

This application is based on and claims priority from Korean Patent Application No. 10-2024-0022912, filed on February 16, 2024, with the Korean Intellectual Property Office.

TECHNICAL FIELD

The present disclosure relates to a battery information generating apparatus and method, and more specifically, to a battery information generating apparatus and method that generates battery information that more accurately reflects the state of a battery.

BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, improving lifespan and safety is also important. In order to improve battery safety, technology that accurately diagnoses the current state of the battery is required.

Based on the fact that the internal resistance of a battery increases as the battery deteriorates, the resistance measured at the beginning of discharge after the end of charging of the battery was used as a degradation index in the past. That is, the resistance calculated based on the amount of voltage change for a predetermined time from the discharge start point after the end of charging was used as a degradation index.

However, as the battery deteriorates, the overvoltage due to polarization increases, so the voltage when measuring resistance actually decreases. And, due to the decrease in voltage, the resistance is also measured to be smaller than the actual value.

In the case of a battery that shows a minimal change in resistance according to voltage in the high-voltage section, the decrease in resistance due to the decrease in voltage is minimal, so there is no great need to correct the measured resistance.

However, in the case of a battery that shows a large change in resistance according to voltage in the high-voltage section, it is necessary to consider the decrease in resistance according to the decrease in voltage. That is, in order to more accurately calculate the resistance as a degradation index, it is necessary to correct the measured resistance by considering the decrease in voltage.

Therefore, a technology is needed that may determine whether the measured resistance corresponds to a battery that needs to be corrected, and if the need for correction is recognized, a technology is needed that may correct the measured resistance by taking into account the voltage decrease.

The prior art relevant to the present invention is given by US 2012/169288 A1 and KR 102 600 139 B1.

DISCLOSURE

Technical Problem

The present disclosure is designed to solve one or more of the problems of the related art. Therefore, some aspects of the present disclosure are directed to providing a battery information generating method and device for determining whether or not a battery requires correction of measured resistance. In the present disclosure, the battery may be a secondary battery and may also be denoted a rechargeable battery.

In addition, some aspects of the present disclosure are directed to providing a battery information generating method and device that corrects the measured resistance by considering the decrease in voltage when the necessity of correction is recognized.

These and other objects and advantages of the present disclosure may be understood from the following detailed description and will become more fully apparent from the exemplary aspects and embodiments of the present disclosure. Also, it will be easily understood that the objects and advantages of the present disclosure may be realized by the means shown in the appended claims.

Technical Solution

A battery information generating method according to a first aspect of the present disclosure may comprise a profile obtaining step of obtaining a differential profile representing a correspondence relationship between a voltage and a differential capacity of a battery; a peak detecting step of detecting a peak in the differential profile; a voltage comparing step of comparing a peak voltage corresponding to the peak with a preset reference voltage; a resistance determining step of determining a resistance for a predetermined time from a discharge start point as a measured resistance by discharging the battery; and a diagnostic resistance determining step of determining a diagnostic resistance of the battery based on the measured resistance according to a comparison result of the voltage comparing step.

The method according to the first aspect of the disclosure accurately reflects the state of the battery. In the first aspect, the battery's resistance is measured and analyzed over a predetermined time to determine the battery's degradation status. As noted, the method may involve obtaining a differential profile representing the relationship between voltage and differential capacity, detecting peaks in this profile, comparing peak voltages to a reference voltage, and determining a measured resistance during battery discharge. If necessary, the measured resistance is corrected based on changes in voltage to derive a more accurate diagnostic resistance. This approach ensures that battery degradation is assessed more precisely, particularly in cases where voltage drops impact resistance measurements.

In some embodiments of the first aspect, the measurement of a resistance for a predetermined time may refer to the process of determining the resistance of a battery during a fixed interval after the discharge cycle begins. This measurement may be for example based on a change in voltage and a discharge current of the battery measured in a discharging cycle of the battery. The resistance may be derived using Ohm's law, which states that resistance (R) is equal to the voltage drop (V) divided by the current (I). In some embodiments, the resistance is calculated by taking the difference between the initial discharge voltage and the voltage after the predetermined time has elapsed and dividing it by the discharge current. This process may thus accounts for the impact of battery degradation, where internal resistance increases over time. However, as the battery deteriorates, polarization effects may cause overvoltage, leading to an artificially lower resistance measurement. Therefore, the first aspect of the disclosure proposes a correction mechanism to adjust the measured resistance, ensuring an accurate assessment of battery health. In some embodiments of the present disclosure, the diagnostic resistance may be used for battery diagnostics. For example, the diagnostic resistance may be considered in determining the State of Health (SOH) and/or State of Charge (SOC) of the battery under evaluation. In addition or alternatively, the battery management by a battery management system (BMS) may be based on the diagnostic resistance directly, or indirectly, by considering the SOH and/or SOC determined based on the diagnostic resistance.

The diagnostic resistance determining step may include a step of determining the measured resistance as the diagnostic resistance when the peak voltage is less than the reference voltage.

The diagnostic resistance determining step may further include a voltage determining step of determining the voltage of the discharge start point as a measured voltage when the peak voltage is greater than or equal to the reference voltage.

The diagnostic resistance determining step may include a measured resistance correcting step of correcting the measured resistance based on the measured voltage, the peak voltage and a preset resistance profile; and a step of determining the corrected measured resistance as the diagnostic resistance.

The resistance profile may be a profile that is preset to correspond to the battery and represents a correspondence relationship between the voltage and a resistance.

The measured resistance correcting step may include a step of calculating a first value based on the measured voltage and a target voltage; a step of calculating a second value based on the target voltage and the resistance profile; a step of calculating a third value based on the first value and the second value; and a step of calculating the corrected measured resistance based on the third value and the measured resistance.

The target voltage may be determined as a voltage that is greater than or equal to the reference voltage among the peak voltages.

The first value may be a difference between the measured voltage and the target voltage.

The second value may be a rate of change of the resistance for the voltage in a target voltage section of the resistance profile.

The target voltage section may be a voltage section greater than or equal to the target voltage.

The third value may be a value obtained by multiplying the first value by the second value.

The corrected measured resistance may be a value obtained by adding the third value to the measured resistance.

A battery information generating apparatus according to a second aspect of the present disclosure may provide an apparatus configured to implement an embodiment of the first aspect of the disclosure. In some embodiments, the battery information generating apparatus according to a second aspect of the present disclosure comprises a profile obtaining unit configured to obtain a differential profile representing a correspondence relationship between a voltage and a differential capacity of a battery; a voltage comparing unit configured to detect a peak in the differential profile and compare a peak voltage corresponding to the peak with a preset reference voltage; a measurement value determining unit configured to determine a resistance for a predetermined time from a discharge start point as a measured resistance by discharging the battery; and a diagnostic resistance determining unit of configured to determine a diagnostic resistance of the battery based on the measured resistance according to a comparison result.

The diagnostic resistance determining unit may be configured to determine the measured resistance as the diagnostic resistance when the peak voltage is less than the reference voltage.

The measurement value determining unit may be configured to determine the voltage of the discharge start point as a measured voltage when the peak voltage is greater than or equal to the reference voltage.

The diagnostic resistance determining unit may be configured to correct the measured resistance based on the measured voltage, the peak voltage and a preset resistance profile, and determine the corrected measured resistance as the diagnostic resistance.

The resistance profile may be a profile that is preset to correspond to the battery and represents a correspondence relationship between the voltage and a resistance.

The diagnostic resistance determining unit may be configured to calculate a first value based on the measured voltage and a target voltage, calculate a second value based on the target voltage and the resistance profile; calculate a third value based on the first value and the second value, and calculate the corrected measured resistance based on the third value and the measured resistance.

A battery pack according to a third aspect of the present disclosure may comprise the battery information generating apparatus according to another aspect of the present disclosure.

One or more computer readable media according to a fourth aspect of the present disclosure may store instructions that, when executed by one or more processing units (e.g. provided in an apparatus for diagnosing a battery), cause the one or more processing units to perform operations that may comprise a profile obtaining step of obtaining a differential profile representing a correspondence relationship between a voltage and a differential capacity of a battery; a peak detecting step of detecting a peak in the differential profile; a voltage comparing step of comparing a peak voltage corresponding to the peak with a preset reference voltage; a resistance determining step of determining a resistance for a predetermined time from a discharge start point as a measured resistance by discharging the battery; and a diagnostic resistance determining step of determining a diagnostic resistance of the battery based on the measured resistance according to a comparison result of the voltage comparing step.

The one or more computer readable media may further store instructions that, when executed by the one or more processing units, may cause the one or more processing units to perform the steps of the method according to one of the embodiments of the first aspect of the present disclosure.

A computer program according to a fifths aspect of the present disclosure, when executed by one or more processing units, cause the one or more processing units (e.g. provided in an apparatus for diagnosing a battery) to perform operations that may comprise a profile obtaining step of obtaining a differential profile representing a correspondence relationship between a voltage and a differential capacity of a battery; a peak detecting step of detecting a peak in the differential profile; a voltage comparing step of comparing a peak voltage corresponding to the peak with a preset reference voltage; a resistance determining step of determining a resistance for a predetermined time from a discharge start point as a measured resistance by discharging the battery; and a diagnostic resistance determining step of determining a diagnostic resistance of the battery based on the measured resistance according to a comparison result of the voltage comparing step.

The computer program, when executed by the one or more processing units, may cause the one or more processing units to perform the steps of the method according to one of the embodiments of the first aspect of the present disclosure.

Advantageous Effects

According to the aspects of the present disclosure, diagnostic resistance may be more accurately determined by determining whether or not the measured resistance needs to be corrected through voltage comparison based on the differential profile.

According to the aspects of the present disclosure, when determining diagnostic resistance as a degradation index, the diagnostic resistance may be determined more accurately by considering the change in voltage during resistance measurement.

According to the aspects of the present disclosure, the diagnostic resistance may be determined more accurately by setting the reference voltage considering the state of the battery.

The effects of the present disclosure are not limited to the effects mentioned above, and other effects not mentioned will be clearly understood by those skilled in the art from the description of the claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a flow chart of a battery information generating method according to an embodiment of the present disclosure.
FIG. 2 is a drawing schematically illustrating a battery information generating apparatus according to an embodiment of the present disclosure.
FIG. 3 is a flow chart more specifically illustrating a voltage comparing step, a resistance determining step, and a diagnostic resistance determining step of the battery information generating method according to an embodiment of the present disclosure.
FIG. 4 is a flow chart illustrating more specifically the measured resistance correcting step of the battery information generating method according to an embodiment of the present disclosure.
FIG. 5 is a drawing schematically illustrating a differential profile according to an embodiment of the present disclosure.
FIG. 6 is a drawing schematically illustrating a resistance profile according to an embodiment of the present disclosure.
FIG. 7 is a drawing illustrating an exemplary configuration of a battery pack according to another embodiment of the present disclosure.

BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, example embodiments of the present disclosure will be described in detail with reference to the accompanying drawings.

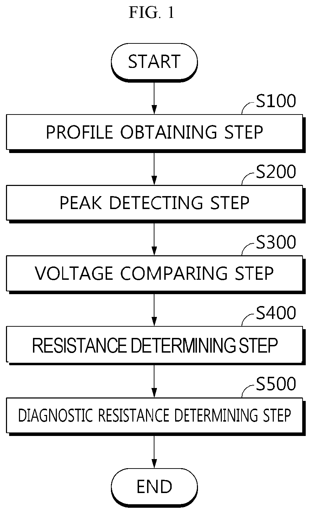

FIG. 1 is a flow chart of a battery information generating method according to an embodiment of the present disclosure.

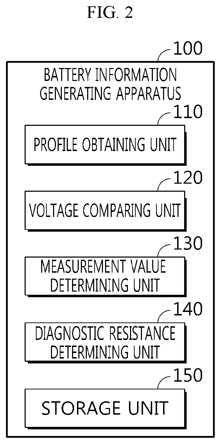

FIG. 2 is a drawing schematically illustrating a battery information generating apparatus 100 according to an embodiment of the present disclosure.

Referring to FIG. 1, the battery information generating method may include a profile obtaining step (S100), a peak detecting step (S200), a voltage comparing step (S300), a resistance determining step (S400), and a diagnostic resistance determining step (S500). Preferably, each step of the battery information generating method may be performed by the battery information generating apparatus 100.

Referring to FIG. 2, the battery information generating apparatus 100 may include a profile obtaining unit 110, a voltage comparing unit 120, a measurement value determining unit 130, and a diagnostic resistance determining unit 140.

In some embodiments, the diagnostic resistance, which may be determined by the diagnostic resistance determining unit 140, may be used for battery diagnostics. The diagnostic resistance may provide insights into the internal state and overall health of the battery under evaluation. Conventionally, the internal resistance increases as a battery deteriorates, and the diagnostic resistance may serve as a key indicator of battery aging and/or degradation. A significant increase in diagnostic resistance over time may suggest one or more of capacity fade, electrode degradation, and/or electrolyte deterioration, all of which contribute to reduced battery performance. In some embodiments, the diagnostic resistance is be used to detect battery state of health (SOH) by comparing the measured resistance to a reference resistance values from a reference battery or the new or minimally aged battery (e.g. the battery in its Beginning of Life (BOL) state). A sudden increase in resistance may for example indicate lithium plating, electrode wear, or loss of active material, which can lead to safety risks such as thermal runaway or premature failure. The SOH states may for example a healthy state (e.g. SOH ≥ 80%), a moderate degraded state (e.g. 80% > SOH ≥ 60%), a significantly degraded state (e.g. 60% > SOH ≥ 40%), a critical state (e.g. 40% > SOH ≥ 20%) and End-of-Life (EOL) state (e.g. 20% > SOH). However, the SOH states mentioned are just an example and the disclosure is not limited by this example; there can be less or more SOH states and/or the percentage ranges of the SOH states may be varied, e.g. depending on the use case of the battery. Furthermore, in addition or as ana alternative, the diagnostic resistance may provide be used to obtain more accurate determinations of the State of Charge (SOC) of the battery. The diagnostic resistance may for example provide insights into the SOC dependency of resistance, which can be used to optimize battery management strategies to prevent excessive stress on the battery during charging and discharging cycles.

In addition to the before mentioned diagnostics or as an alternative, the diagnostic resistance may be used in battery management systems (BMS). For example, the BMS may base the battery management on the diagnostic resistance, i.e. the diagnostic resistance may be used as one parameter in battery management. By continuously monitoring diagnostic resistance, the BMS can predict failures, optimize charging cycles, and extend battery lifespan by adjusting operational parameters accordingly. For example, the BMS may adjust the charging parameters of the battery. For example, if the diagnostic resistance increases, indicating aging or degradation, the BMS may reduce the charging current to prevent excessive heat generation and prolong battery lifespan. In another example, BMS may also modify the charging cut-off voltage to prevent stress on aging electrodes, which helps mitigate lithium plating and capacity fade. In yet another example, BMS may limit high-C-rate charging if resistance exceeds a threshold to prevent thermal runaway. In a further example, the BMS may limit the discharge current. For example, BMS can limit the maximum discharge current when resistance is high to prevent voltage sag and ensure stable power output. Furthermore, in another example, BMS can adjust cooling system activation (e.g., when using the battery in electric vehicles, EVs) to prevent overheating in high-resistance battery cells. The BMS may also perform safety measures, e.g. the BMS may shut down charging and discharging operations to prevent hazards, if the diagnostic resistance exceeds a critical limit, indicating a faulty or unsafe cell. In extreme cases, BMS could also isolate defective cells in a multi-cell battery pack to protect the remaining cells from damage.

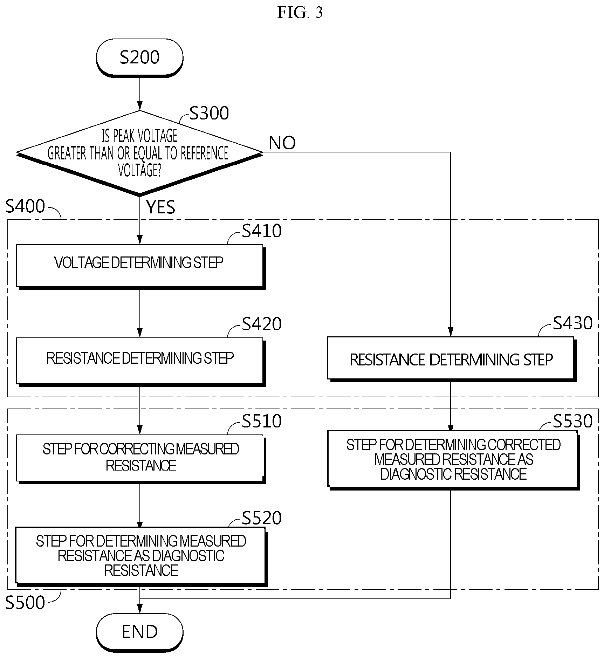

FIG. 3 is a flow chart more specifically illustrating a voltage comparing step (S300), a resistance determining step (S400), and a diagnostic resistance determining step (S500) of the battery information generating method according to an embodiment of the present disclosure. Here, the battery refers to one or more independent cells. The battery may have a negative terminal and a positive terminal. More specifically, each of the battery cells may be a physically separable unit. Each of the battery cells may have a negative terminal and a positive terminal. The negative terminals and positive terminals of the battery cells may be connected in series or in parallel to provide a negative terminal and positive terminal of the battery. A battery may be for example, a lithium-ion battery or a lithium polymer battery. In addition, battery may be of any type, such as for example a cylindrical battery type, a prismatic battery type or a pouch battery type. Additionally, the battery may also be a battery bank, a battery module or a battery pack in which a plurality of cells are connected in series and/or parallel. Below, for convenience of explanation, the battery is explained as meaning one independent cell.

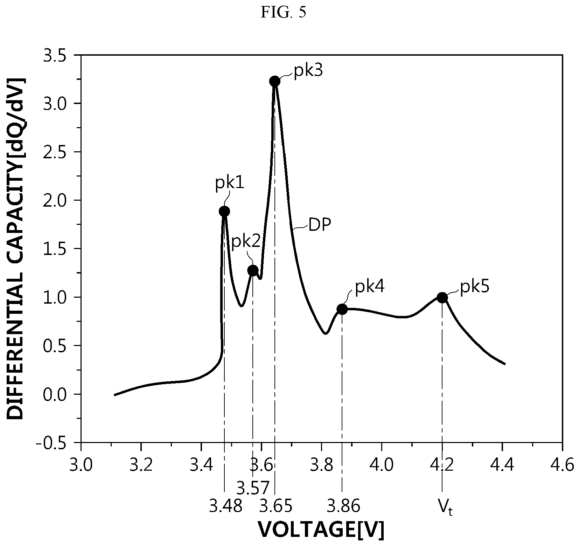

FIG. 5 is a drawing schematically illustrating a differential profile DP according to an embodiment of the present disclosure. The differential profile DP may represent the correspondence relationship between the differential capacity (dQ/dV) and the voltage (V) of a battery. the differential capacity (dQ/dV) may for example represents the instantaneous rate of change of capacity (Q) with respect to voltage (V). For example, the differential capacity (dQ/dV) may be expressed the value obtained by differentiating the capacity (Q) with respect to voltage (V). The capacity of the battery may be derived from the voltage (V) and/or current (I) measurements of a measurement unit, such as the measurement module 112. The measurements may be performed in a charging and/or discharging cycle of the battery. In some example implementations, the capacity (Q) of the battery may be determined based on the current measurements using Coulomb counting. For example, the profile obtaining unit 110 or the measurement module 112 may integrate the current measurements over time to estimate the capacity (Q) of the battery. Optionally, the capacity (Q) of the battery may be adjusted to consider internal resistance, polarization, and electrochemical effects of the battery. Such adjustments or corrections may be based on the voltage measurements, e.g. measurements of the terminal voltage and/or open circuit voltage (OCV).

The differential profile DP may be, for example, a data structure that interrelates (or corelates) respective values of the differential capacity (dQ/dV) of a battery to corresponding values of the voltage (V) of the battery for the respective values of the differential capacity (dQ/dV) (or vice versa). The differential profile DP may be determined in charging process of the battery. The differential profile DP may for example represented in a two-dimensional data array. In some embodiments, the differential profile DP may be representable as a two-dimensional differential profile DP, where one axis of the differential profile DP (e.g. the X-axis) denotes values of the voltage (V) of the battery and another axis of the differential profile DP (e.g. the Y-axis) denotes values of the differential capacity (dQ/dV) of a battery that correspond to the respective values of the voltage (V) of the battery.

The number of pairs of differential capacity values of the differential capacity (dQ/dV) of the battery and corresponding voltage values of the voltage (V) of the battery in the differential profile DP may be determined by the number of measurements. Optionally, interpolation may be used to generate intermediate pairs of differential capacity values of the differential capacity (dQ/dV) of the battery and corresponding values of the voltage (V) of the battery in the differential profile DP from the measurement-based pairs of values of the differential capacity (dQ/dV) of the battery and the corresponding values of the measured voltage (V) of the battery in the differential profile DP. As noted, individual pairs of differential capacity values of the differential capacity (dQ/dV) and the corresponding voltage values of the voltage (V) of the battery may be obtained in a charging process of the battery. The individual pairs of values of differential capacity values of the differential capacity (dQ/dV) and corresponding values of the of the voltage (V) of the battery may be obtained in a charging process of the battery in intervals, such as, for example, predetermined or configurable time intervals.

The measured voltage (V) may be a terminal voltage of the battery. The terminal voltage may be measured across the terminals of the battery while the battery is being charged. In this case, the interval between measurements for generating respective pairs of the differential capacity (dQ/dV) and voltage (V) may be a predetermined or configurable time interval.

In the embodiment of FIG. 5, the horizontal axis (X-axis) represents voltage (V), and the vertical axis (Y-axis) represents differential capacity (dQ/dV).

The profile obtaining step (S100) is a step of obtaining a differential profile DP representing a correspondence relationship between the voltage (V) and differential capacity (dQ/dV) of the battery. The profile obtaining step (S100) may be performed by the profile obtaining unit 110.

A battery profile BP may a profile that represents the correspondence relationship between voltage (V) and capacity (Q) while the battery is being charged. A differential profile DP may represent the correspondence relationship between differential capacity (dQ/dV) and voltage (V). The differential profile DP may be generated by differentiating a battery profile BP representing a correspondence relationship between capacity (Q) of the battery and voltage (V) of the battery. The battery profile BP may thus be obtained during the process of charging the battery, and the differential profile DP may be obtained from the battery profile BP.

The battery profile BP may be, for example, a data structure that interrelates (or corelates) respective values of the capacity (Q) of a battery to corresponding values of the voltage (V) of the battery for the respective values of the capacity (Q) (or vice versa). The battery profile BP may be determined in charging process of the battery. The battery profile BP may for example represented in a two-dimensional data array. In some embodiments, the battery profile BP may be representable as a two-dimensional battery profile BP, where one axis of the battery profile BP (e.g. the X-axis) denotes values of the voltage (V) of the battery and another axis of the battery profile BP (e.g. the Y-axis) denotes values of the capacity (Q) of a battery that correspond to the respective values of the voltage (V) of the battery.

The number of pairs of differential capacity values of the capacity (Q) of the battery and corresponding voltage values of the voltage (V) of the battery in the battery profile BP may be determined by the number of measurements. Optionally, interpolation may be used to generate intermediate pairs of differential capacity values of the capacity (Q) of the battery and corresponding values of the voltage (V) of the battery in the battery profile BP from the measurement-based pairs of values of the capacity (Q) of the battery and the corresponding values of the measured voltage (V) of the battery in the battery profile BP. As noted, individual pairs of differential capacity values of the capacity (Q) and the corresponding voltage values of the voltage (V) of the battery may be obtained in a charging process of the battery. The individual pairs of values of differential capacity values of the capacity (Q) and corresponding values of the of the voltage (V) of the battery may be obtained in a charging process of the battery in intervals, such as, for example, predetermined or configurable time intervals. The measured voltage (V) may be a terminal voltage of the battery. The terminal voltage may be measured across the terminals of the battery while the battery is being charged. In this case, the interval between measurements for generating respective pairs of the capacity (Q) and voltage (V) may be a predetermined or configurable time interval. There is no special limitation on the C-rate in charging for generating a battery profile. The battery should be charged at a low rate in order to obtain a more accurate battery profile BP and (thus) the differential profile DP. For example, the battery profile BP may be generated in the process of charging the battery at 0.15 C or lower, preferably 0.1 C or lower, and more preferably 0.05 C or lower.

For example, the profile obtaining unit 110 may directly obtain/receive the differential profile DP of the battery from the outside. That is, the profile obtaining unit 110 may obtain/receive the differential profile DP of the battery from an external device or unit. The external device or unit may connected to the profile obtaining unit 110 by wire and/or wirelessly and receiving the differential profile DP. The external device or unit may be comprised by the battery information generating apparatus 100 or may be an external entity.

In some other embodiments, the profile obtaining unit 110 may be configured to generate the differential profile DP. For this, the profile obtaining unit 110 may receive battery information about the voltage and capacity of the battery. In some embodiments, the profile obtaining unit 110 may be configured to control a measurement unit (for example, measuring unit 112, see FIG. 8). The measurement unit may be configured to measure pairs of measurement values of the current (I) and the voltage (V) of the battery and may derive a capacity (Q) based on the measurements. The measurement unit may be configured to provide the pairs of values of the capacity (Q) and the voltage (V) of the battery as battery information to the profile obtaining unit 110. Then, the profile obtaining unit 110 may directly generate a differential profile DP based on the received battery information or the profile obtaining unit 110 may generate a battery profile BP based on the battery information and obtain the differential profile BP by differentiating the battery profile BP with respect to voltage.

As still further embodiments, the profile obtaining unit 110 may measure the voltage (V) and current (I) of the battery. For example, the profile obtaining unit 110 may be connected to the positive electrode terminal and the negative electrode terminal of the battery to measure the voltage of the battery. In addition, the profile obtaining unit 110 may measure the charge/discharge current of the battery and calculate the capacity of the battery based on the measured current. In addition, the profile obtaining unit 110 may generate a differential profile DP based on the voltage and capacity of the battery or the profile obtaining unit 110 may generate a battery profile BP based on the battery information and obtain the differential profile BP by differentiating the battery profile BP with respect to voltage.

The peak detecting step (S200) is a step of detecting a peak in the differential profile DP. The peak detecting step (S200) may be performed by the voltage comparing unit 120.

Here, a peak may refer to a point of the differential profile DP where the slope (instantaneous rate of change) of the profile changes from a positive (+) value to a negative (-) value. That is, the slope on the low voltage side centered on the peak is positive, and the slope on the high voltage side is negative. In other words, a peak may correspond to a (local or absolute) maximum of the differential profile BP.

Referring to FIG. 5, multiple peaks (pk1, pk2, pk3, pk4, pk5) may be detected in the differential profile DP.

The voltage comparing unit 120 may compare the peak voltage corresponding to the peak with a preset reference voltage.

Here, the reference voltage may be preset to reflect the state of the battery. Alternatively, the reference voltage may be preset to a predetermined voltage value (e.g., 4 V).

In the following, the description is made assuming that the reference voltage is preset to 4 V. In addition, for convenience of explanation, a specific example of setting the reference voltage by reflecting the state of the battery is described later.

For example, the voltage comparing unit 120 may compare the magnitude of the peak voltage of the peak and the reference voltage. Specifically, the voltage comparing unit 120 may determine whether the peak voltage of the peak is equal to or greater than a reference voltage. Here, the peak voltage being equal to or greater than the reference voltage means that the voltage corresponding to at least one peak among the plurality of peaks is equal to or greater than the reference voltage. In other words, the voltage comparing unit 120 may determine whether the peak voltage is less than the reference voltage. Here, the peak voltage being less than the reference voltage means that the voltage corresponding to each of the plurality of peaks is all less than the reference voltage.

In the embodiment of FIG. 5, the peak voltage corresponding to the peak (pk1) is 3.48 V, the peak voltage corresponding to the peak (pk2) is 3.57 V, the peak voltage corresponding to the peak (pk3) is 3.65 V, the peak voltage corresponding to the peak (pk4) is 3.86 V, and the peak voltage corresponding to the peak (pk5) is 4.20 V. When comparing the magnitude of each peak voltage and the reference voltage, the peak voltage (3.48 V) corresponding to the peak (pk1), the peak voltage (3.57 V) corresponding to the peak (pk2), the peak voltage (3.65 V) corresponding to the peak (pk3), and the peak voltage (3.86 V) corresponding to the peak (pk4) are less than the reference voltage (4 V). In addition, the peak voltage (4.2 V) corresponding to the peak (pk5) is greater than or equal to the reference voltage (4 V). Since the voltage corresponding to at least one peak (pk5) among multiple peaks (pk1, pk2, pk3, pk4, pk5) is greater than or equal to the reference voltage, the voltage comparing unit 120 may determine that the peak voltage is greater than or equal to the reference voltage.

The resistance determining step (S400) is a step of determining the resistance for a predetermined time from a discharge start point as the measured resistance by performing a discharge on the battery. The resistance determining step (S400) may be performed by the measurement value determining unit 130.

Specifically, the measurement value determining unit 130 may determine the resistance change amount for a predetermined time from the time point at which the next discharge cycle starts after the end of the charge cycle in which the differential profile DP is obtained, as the measured resistance.

More specifically, the battery may be charged until the voltage (or SOC) reaches a preset charging termination voltage (or preset charging termination SOC). Then, the measurement value determining unit 130 may determine or calculate the resistance of the battery based on the voltage change amount and the discharge current from the start point of the discharge cycle until a predetermined time elapses after the charge cycle is terminated.

For example, it is assumed that the discharge current is Id, the discharge start voltage is Vi, and the voltage after a predetermined time has elapsed after the discharge start is Vf. In this case, the measurement value determining unit 130 may calculate the measured resistance $R_m$ by calculating the formula $R_m = \dfrac{V_i - V_f}{I_d}$ using Ohm's law. In addition, the predetermined time here may be a preset time experimentally or theoretically. For example, the predetermined time may be preset to 0.1 second, 1 second, or 60 seconds. The discharge current Id may be for example measured at the time of measurement of the discharge start voltage Vi or after a predetermined time has elapsed after the discharge start, e.g. at the time of measuring the voltage Vf or earlier. It may be assumed, for example, that the discharge current Id is constant in the time interval between measuring voltage Vi and voltage Vf, so that the discharge current may be a current measured at the time of measuring Vi or Vf or in between those measurements. Alternatively, the current may be repeatedly measured in the predetermined time interval between the measurements of Vi and Vf and the discharge current Id may be defined as the average current $I_{average}$ of the currents measured in the predetermined time interval, i.e. $R_m = \frac{V_i - V_f}{I_d} = \frac{V_i - V_f}{I_{average}}$.

The diagnostic resistance determining step (S500) is a step of determining the diagnostic resistance of the battery based on the measured resistance according to the comparison result of the voltage comparing step (S300). The diagnostic resistance determining step (S500) may be performed by the diagnostic resistance determining unit 140. The diagnostic resistance determining step (S500) may include a measured resistance correcting step (S510), a step of determining the corrected measured resistance as the diagnostic resistance (S520), and a step of determining the measured resistance as the diagnostic resistance (S530).

If the peak voltage is less than the reference voltage, the diagnostic resistance determining unit 140 may determine the measured resistance $R_m$ as the diagnostic resistance without correction for the measured resistance. Conversely, if the peak voltage is greater than or equal to the reference voltage, the diagnostic resistance determining unit 140 may correct the measured resistance and determine the corrected measured resistance as the diagnostic resistance. As outlined in more detail below, the correction of the resistance may, for example, aim to compensate for an underestimation or erroneous estimation of the measured resistance $R_m$ due to voltage drop caused by battery degradation. Since the internal resistance of a battery increases as it deteriorates, but polarization effects lead to a decrease in measured voltage, the initially calculated resistance $R_m$ may be lower than the actual value. To address this, the correction method may for example adjust the measured resistance $R_m$ by considering the difference between the measured voltage $V_m$ at the discharge start (which may be equal to the voltage Vi) and a target voltage $V_t$ derived from the battery's differential profile BP. Using a predefined resistance profile, which maps resistance as a function of voltage, the rate of change of resistance in the relevant voltage range may be determined and the correction may then be applied by multiplying the voltage difference by this rate of change of the resistance and adding the result to the measured resistance $R_m$, ensuring a more accurate diagnostic resistance that better reflects the battery's true state.

Referring to FIG. 3, in step S300, it may be determined whether the peak voltage of a given peak in the differential profile DP is greater than or equal to the reference voltage. If the result of step S300 is YES, step S410 is performed. If the result of step S300 is NO, step S430 is performed.

Step S410 is a step of determining the voltage of the discharge start point as a measured voltage. Step S410 may be performed by the measurement value determining unit 130. In some embodiments, the discharge start point may be for example the moment when a new discharge cycle begins after the completion of a charging cycle. For example, the battery may be charged until it reaches a preset charge termination voltage or state of charge (SOC) or charging is interrupted by the user. The discharge start point may thus refer to a point in time after charging ends and when the battery starts discharging. The voltage of the discharge start point may thus refer to the battery voltage at the moment when a new discharge cycle begins after the completion of a charging cycle. This voltage is denoted Vi and sometimes also $V_m$.

That is, the resistance determining step (S400) may further include a voltage determining step (S410) that determines the voltage Vi of the discharge start point as the measured voltage $V_m$ if the peak voltage is greater than or equal to the reference voltage.

Specifically, the measurement value determining unit 130 may determine the voltage Vi at the time point when the next discharge cycle starts after the charge cycle in which the differential profile DP is obtained is terminated, as the measured voltage $V_m$.

More specifically, the battery may be charged until the voltage (or SOC) reaches a preset charge termination voltage (or preset charge termination SOC). Then, the measurement value determining unit 130 may determine the voltage Vi at the start point of the discharge cycle as the measured voltage $V_m$ after the charge cycle is terminated.

Step S420 is a step for determining measured resistance. Step S420 may be performed by the measurement value determining unit 130. Meanwhile, steps S420 and S430 are the same steps for determining measured resistance but are illustrated separately in FIG. 3 for convenience of explanation.

After the resistance determining step (S420), step S510 may be performed. Step S510 is a step for correcting the measured resistance Rm. Step S510 may be performed by the diagnostic resistance determining unit 140. For example, the diagnostic resistance determining unit 140 may correct the measured resistance Rm based on the measured voltage $V_m$, peak voltage, and preset resistance profile.

Step S520 is a step of determining the corrected measurement resistance as the diagnostic resistance, which may be performed by the diagnostic resistance determining unit 140. After the measurement resistance determining step (S430), step S530 may be performed. Step S530 is a step of determining the measurement resistance as the diagnostic resistance, and may be performed by the diagnostic resistance determining unit 140.

An embodiment of the battery information generating method according to the present disclosure may more accurately determine diagnostic resistance by determining whether or not the measurement resistance needs to be corrected through voltage comparison based on a differential profile. That is, the diagnostic resistance may be determined differently depending on the type of battery (e.g., high nickel battery, low nickel battery, etc.).

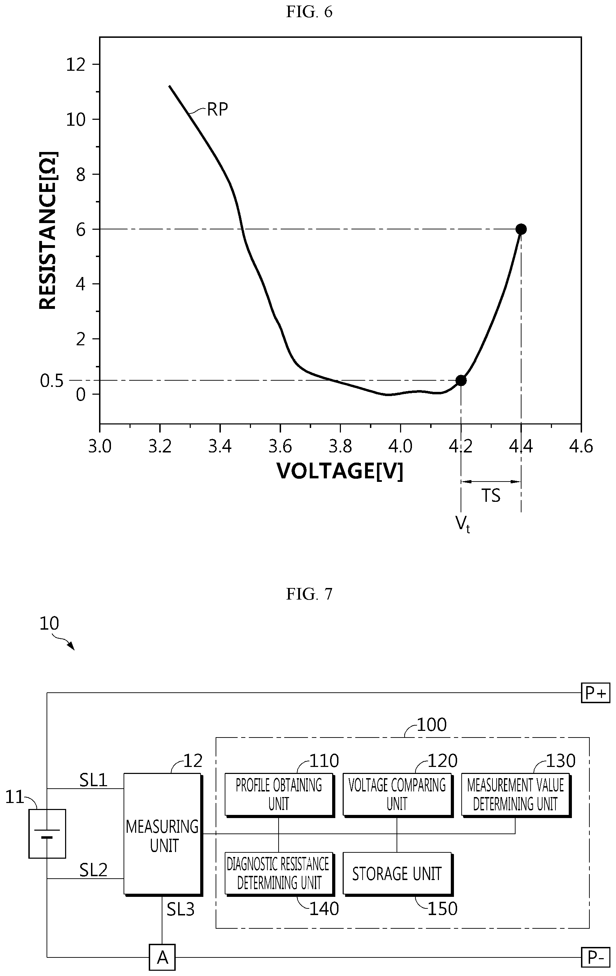

FIG. 6 is a drawing schematically illustrating a resistance profile RP according to an embodiment of the present disclosure. In the embodiment of FIG. 6, the horizontal axis (X-axis) represents voltage (V), and the vertical axis (Y-axis) represents resistance (Ω). The resistance profile RP may be a profile that is preset to correspond to the battery and represents the reference correspondence relationship between voltage (V) and resistance (R) of the battery.

For example, the voltage (V) in the resistance profile RP may be an open circuit voltage (OCV) of the battery or a terminal voltage of the battery. Resistance may be calculated based on the voltage change amount when a pulse signal is applied to the battery. For example, the resistance may be calculated based on the voltage change amount recorded for 0.1 second when a pulse signal (e.g. having a C-rate of 0.5C) is given and Ohm's law. In another example, the resistance of the resistance profile RP may be calculated based on the amount of change in voltage $\Delta V$ (e.g. a voltage difference observed) when a charging signal (at a given C-rate) is applied to the battery for a predetermined amount of time. The charging signal may be for example short-duration current pulse $I_{pulse}$ (e.g. 0.1 s, 1.0 s, 60 s, etc.), and the resistance R may be calculated as $R = \frac{\Delta V}{I_{pulse}}$.

In some embodiments, the resistance profile RP may represent the reference correspondence relationship between the voltage (V) and resistance (R) measured during the charging process of a given reference battery. The reference battery may be a battery having the same specifications as the battery under evaluation, e.g. a reference battery that shares key design and performance characteristics with the battery under evaluation. A battery with similar specifications may for example mean a reference battery that closely matches the battery under evaluation in chemistry, form factor, capacity, voltage range, internal resistance behavior, and manufacturing materials. This similarity may ensure that the preset resistance profile RP remains valid for correcting measured resistance values, leading to more accurate battery diagnostics.

As another example, the resistance profile RP may be preset to represent the reference correspondence relationship between the voltage (V) and resistance (R) measured during the charging process when the battery is in the BoL (Beginning of Life) state.

A specific but non-limiting example in which the diagnostic resistance determining unit 140 corrects the measured resistance in step S510 is described in more detail.

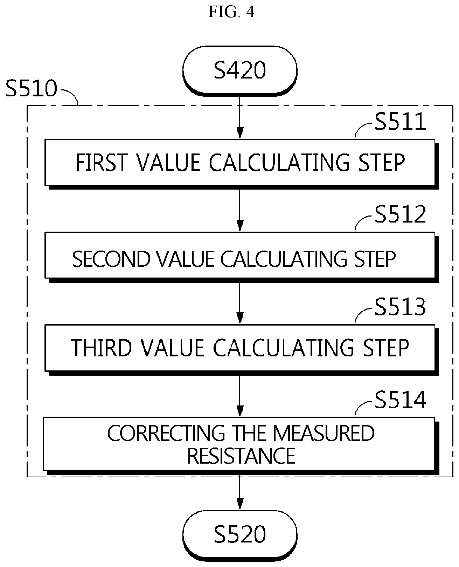

FIG. 4 is a flow chart illustrating more specifically the measured resistance correcting step (S510) of the battery information generating method according to an embodiment of the present disclosure.

Referring to FIG. 4, step S510 may include a first value calculating step (S511), a second value calculating step (S512), a third value calculating step (S513), and a step of correcting the measured resistance (S514).

Step S511 is a step of calculating a first value based on the measured voltage $V_m$ and the target voltage $V_t$. Step S511 may be performed by the diagnostic resistance determining unit 140 after step S420. In step 511, the target voltage $V_t$ may be determined as a peak voltage that is greater than or equal to the reference voltage. Since step S510 is performed when the peak voltage is greater than or equal to the reference voltage, if there is one peak detected in the peak detecting step (S200), the voltage corresponding to that peak may be determined as the target voltage $V_t$. If there are multiple peaks detected in the peak detecting step (S200), the voltage of a peak among the multiple peaks whose corresponding voltage is greater than or equal to the reference voltage may be determined as the target voltage Vt.

In some cases, there may be multiple target peaks among the multiple peaks whose corresponding voltage is greater than or equal to the reference voltage. In this case, preferably, the largest voltage among the voltages of the multiple target peaks may be determined as the target voltage $V_t$.

Specifically, the diagnostic resistance determining unit 140 may calculate the difference between the measured voltage $V_m$ and the target voltage $V_t$, i.e. $V_m - V_t$, as the first value.

In the embodiment of FIG. 5, the voltage (4.2 V) of a peak (pk5) among a plurality of peaks (pk1, pk2, pk3, pk4, pk5) whose corresponding voltage is greater than or equal to the reference voltage (4 V). Thus, the voltage (4.2 V) of a peak (pk5) may be determined as the target voltage ($V_t$). Assuming that the measured voltage is $V_m$, the first value may be expressed as ($V_m - V_t$), which is the difference between the measured voltage ($V_m$) and the target voltage ($V_t$).

Step S512 is a step of calculating a second value based on the target voltage and the resistance profile RP. Step S512 may be performed by the diagnostic resistance determining unit 140.

Specifically, the diagnostic resistance determining unit 140 may determine the rate of change of resistance with respect to voltage in the target voltage section (TS) of the resistance profile RP as a second value.

The target voltage section (TS) may be a voltage range greater than or equal to the target voltage ($V_t$). That is, the lower limit of the target voltage section (TS) may be set to the target voltage ($V_t$), and the upper limit may be set to the highest voltage defining the upper limit of the resistance profile RP. The target voltage section (TS) may thus be a voltage range between and including the target voltage ($V_t$) and the high voltage of the resistance profile RP. In the embodiment of FIG. 6, the target voltage ($V_t$) is 4.2 V and the upper limit of the resistance profile RP is 4.4 V, so the target voltage section (TS) may be set to a voltage section of 4.2 V to 4.4 V.

The second value may be obtained based on a linear approximation of how resistance changes with voltage in the target voltage range TS. For example, the second value may be set to the slope of a function obtained by linearly approximating a function representing the correspondence relationship between the voltage included in the target voltage section (TS) and the resistance corresponding to the voltage. That is, the slope when the resistance is expressed as a linear function of the voltage may be set to the second value. For example, the second value $a$ may be determined as follows:

$$a = (R_{upper} - R_{lower}) / (V_{upper} - V_{lower})$$

where $R_{upper}$ is the resistance at the upper boundary of the target voltage section (TS), $R_{lower}$ is the resistance at the lower boundary of the target voltage section (TS), $V_{upper}$ is the voltage at the upper boundary of the target voltage section (TS), $V_{lower}$ is the resistance at the lower boundary of the target voltage section (TS), i.e. the target voltage ($V_t$).

Hence, the second value may be set to the average rate of change of resistance with respect to voltage in the target voltage section (TS). In the embodiment of FIG. 6, the average rate of change (i.e., (6 - 0.5) ÷ (4.4 - 4.2) = 27.5) based on the lower limit voltage (or starting voltage, e.g., 4.2 V), the upper limit voltage (or ending voltage, e.g., 4.4 V), the resistance corresponding to the lower limit voltage (e.g., 0.5Ω), and the resistance corresponding to the upper limit voltage (e.g., 6Ω) of the target voltage section (TS) may be set as the second value.

As another example, the second value may be set to the target voltage ($V_t$) of the target voltage section (TS) and the instantaneous rate of change in resistance corresponding to the target voltage ($V_t$). In the embodiment of FIG. 6, the instantaneous rate of change in the target voltage ($V_t$, e.g., 4.2 V) and the resistance corresponding to the target voltage (e.g., 0.5Ω) may be set as the second value.

Preferably, the second value may be set to the slope of a linear approximation function for the target voltage section (TS).

Step S513 is a step of calculating a third value based on the first value and the second value. Step S513 may be performed by the diagnostic resistance determining unit 140.

Specifically, the diagnostic resistance determining unit 140 may calculate a third value by multiplying the first value and the second value. Here, the third value is a constant for correcting the measured resistance.

Step S514 is a step of calculating a corrected measured resistance based on the third value and the measured resistance. Step S514 and may be performed by the diagnostic resistance determining unit 140. The diagnostic resistance determining unit 140 may calculate the corrected measured resistance ($R_{calib}$) by adding the measured resistance and the third value. For example, the corrected measured resistance may be calculated using Formula 1 below.

[Formula 1]

$$R_{calib} = R_m + (V_m - V_t) \times a$$

Here, $R_{calib}$ represents the corrected measured resistance, and $R_m$ represents the measured resistance. $V_m$ represents the measured voltage, $V_t$ represents the target voltage, and $a$ represents the rate of change of resistance with respect to voltage in the target voltage section (TS).

Because the internal resistance of the battery increases as the battery deteriorates, the measured resistance was used as a degradation index in the past. That is, the resistance calculated based on the voltage change amount for a predetermined time from the discharge start point after the end of charging was used as a degradation index. However, as the battery deteriorates, the overvoltage due to polarization (e.g., ohmic polarization, activation polarization, concentration polarization, etc.) increases, so the measured voltage actually gradually decreases. Further, due to the decrease in measured voltage, the resistance is also measured to be smaller than the actual value. Therefore, to more accurately calculate the resistance as a degradation index, it is necessary to correct the measured resistance by considering the decrease in measured voltage.

The battery information generating method according to an embodiment of the present disclosure may more accurately determine diagnostic resistance by considering the change in voltage during resistance measurement when determining the diagnostic resistance as a degradation index. That is, the diagnostic resistance may be more accurately determined by considering the decrease in resistance due to a decrease in measured voltage caused by battery degradation.

Below, a specific example of setting the reference voltage by reflecting the state of the battery is described. For example, the reference voltage may be set by considering the negative electrode flat section of the battery. Specifically, the reference voltage may be set to a voltage corresponding to the lower limit capacity of the negative electrode flat section in the battery profile BP representing a correspondence relationship between capacity (Q) of the battery and voltage (V) of the battery. That is, the reference voltage and the lower limit capacity of the negative electrode flat section in the battery profile BP may exhibit a correspondence relationship.

In general, it is known that in the high-capacity section, the positive electrode of the battery takes the lead in the reaction, and the negative electrode of the battery participates relatively less in the reaction. Due to the different reaction participation of the positive and negative electrodes of the battery, the capacity section where the rate of change in voltage with respect to capacity is insignificant may be called the negative electrode flat section. The negative electrode flat section may refer to a capacity section in which the change of the voltage of the negative electrode due to an increase in the capacity of the negative electrode is minimal. In other words, a capacity section in which the voltage change for the capacity is below a certain level may be preset as a negative electrode flat section.

In one embodiment, the negative electrode flat section may be set as a capacity section in which the rate of change of voltage with respect to capacity in a reference negative electrode profile is less than or equal to a preset criterion ratio. The lower limit capacity of the negative electrode flat section may thus refer to the smallest capacity value at which the voltage of the negative electrode begins to stabilize in the battery profile of the battery. In this region, the negative electrode exhibits a relatively flat voltage response despite changes in capacity, which may be for example indicate a stable phase of lithium intercalation for lithium-based batteries. Before reaching this lower limit, the voltage of the negative electrode typically increases more steeply with capacity, whereas beyond this point, the voltage remains nearly constant over a range of capacities.

In some examples, the reference negative electrode profile may be a profile representing a correspondence relationship between the capacity and voltage of a reference negative electrode to correspond to the negative electrode of a battery. For example, the reference negative electrode may be a negative electrode coin half-cell or a negative electrode of a 3-electrode cell.

In another embodiment, the negative electrode flat section may be a capacity section greater than or equal to the capacity of the reference peak included in a reference differential profile. Thus, the capacity of the reference peak may be set as the lower limit of the negative electrode flat section. The reference differential profile may be a differential profile representing a correspondence relationship between a voltage and a differential capacity of a reference battery or the battery. The reference differential profile may be obtained in a manner similar to that described with respect to the differential profile DP above. In one example the reference battery may be the battery under evaluation in its BOL state.

The reference peak may be set as a peak located in a higher capacity section than the minimum point of the corresponding differential voltage in the reference differential profile. Thus, the capacity of the reference peak may be greater than or equal to the capacity corresponding to the lowest differential voltage in the reference differential profile. The reference peak may denote a point in the reference differential profile where a significant electrochemical reaction occurs. In some embodiments, the reference peak may be selected based on its position relative to the negative electrode flat section in the battery profile. For example, the reference voltage may set at the voltage corresponding to the lower limit capacity of this flat section, ensuring that resistance measurements account for voltage changes in a way that reflects the battery's actual state.

The reference differential profile may be a profile that represents the correspondence relationship between the capacity Q and differential voltage dV/dQ of the battery. The differential voltage may thus represent the instantaneous rate of change of voltage with respect to the capacity. For example, the differential voltage dV/dQ may be value obtained by differentiating voltage V with respect to the capacity Q.

The reference differential profile may be obtained by differentiating the battery profile with respect to the capacity. The reference differential profile is a profile representing the correspondence relationship between the voltage (V) and the capacity (Q) while the battery is being charged. Hence, the battery profile is obtained during the process of charging the battery, and the reference differential profile may be obtained from the battery profile.

The profile obtaining unit 110 may be configured to obtain a reference differential profile. For example, the profile obtaining unit 110 may directly obtain/receive a reference differential profile of the battery from the outside. That is, the profile obtaining unit 110 may obtain/receive the differential profile DP of the battery from an external device or unit. The external device or unit may connected to the profile obtaining unit 110 by wire and/or wirelessly and receiving the differential profile DP.

In some other embodiments, the profile obtaining unit 110 may be configured to generate the battery profile BP. For example, the profile obtaining unit 110 may obtain/receive battery information about voltage (V) and capacity (Q) of the battery. Then, the profile obtaining unit 110 may directly generate a reference differential profile based on the received battery information. As still another example, the profile obtaining unit 110 may measure voltage and current of the battery and calculate capacity. Then, the profile obtaining unit 110 may generate a reference differential profile based on the voltage and capacity of the battery.

In another embodiment, the reference peak may be set to a peak located in a predetermined capacity section in the reference differential profile.

The battery information generating method according to an embodiment of the present disclosure sets a

EP 4 603 854 B1

reference voltage by considering the state of the battery, so that the diagnostic resistance may be determined more accurately.

Meanwhile, the profile obtaining unit 110, the voltage comparing unit 120, the measurement value determining unit 130 and the diagnostic resistance determining unit 140 included in the battery information generating apparatus 100 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the profile obtaining unit 110, the voltage comparing unit 120, the measurement value determining unit 130 and the diagnostic resistance determining unit 140 may be implemented as a set of program modules. At this time, the program module may be stored in the memory and executed by the profile obtaining unit 110, the voltage comparing unit 120, the measurement value determining unit 130 and the diagnostic resistance determining unit 140. The memory may be inside or outside the profile obtaining unit 110, the voltage comparing unit 120, the measurement value determining unit 130 and the diagnostic resistance determining unit 140 and may be connected to the profile obtaining unit 110, the voltage comparing unit 120, the measurement value determining unit 130 and the diagnostic resistance determining unit 140 by various well-known means.

In addition, the battery information generating apparatus 100 may further include a storage unit 150. The storage unit 150 may store data necessary for operation and function of each component of the battery information generating apparatus 100, data generated in the process of performing the operation or function, or the like. The storage unit 150 is not particularly limited in its kind as long as it is a known information storage means that can record, erase, update and read data. As an example, the information storage means may include RAM, flash memory, ROM, EEPROM, registers, and the like. In addition, the storage unit 150 may store program codes in which processes executable by the profile obtaining unit 110, the voltage comparing unit 120, the measurement value determining unit 130 and the diagnostic resistance determining unit 140 are defined.

Specifically, the storage unit 150 may store information necessary for the profile obtaining unit 110, the voltage comparing unit 120, the measurement value determining unit 130, and the diagnostic resistance determining unit 140 to generate information of the battery. For example, the storage unit 150 may store a reference voltage, a resistance profile RP, a reference negative electrode profile, and a criterion ratio. In addition, the profile obtaining unit 110, the voltage comparing unit 120, the measurement value determining unit 130, and the diagnostic resistance determining unit 140 may access the storage unit 150 to obtain information necessary for diagnosing the state of the battery.

The battery information generating apparatus 100 according to the present disclosure may be applied to a battery management system (BMS). That is, the BMS according to the present disclosure may include the battery information generating apparatus 100 described above. In this configuration, at least some of components of the battery information generating apparatus 100 may be implemented by supplementing or adding functions of the components included in a conventional BMS. For example, the profile obtaining unit 110, the voltage comparing unit 120, the measurement value determining unit 130, the diagnostic resistance determining unit 140 and the storage unit 150 of the battery information generating apparatus 100 may be implemented as components of the BMS.

Additionally, the battery information generating apparatus 100 according to the present disclosure may be provided in the battery pack. That is, the battery pack according to the present disclosure may include the above-described battery information generating apparatus 100 and at least one battery cell. Additionally, the battery pack may further include electrical components (relays, fuses, etc.) and a case.

FIG. 7 is a drawing showing an exemplary configuration of a battery pack 10 according to still another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1 and connected to the negative electrode terminal of the battery 11 through the second sensing line SL2. The measuring unit 12 may measure the voltage of the battery 11 based on the voltage measured at each of the first sensing line SL1 and the second sensing line SL2.

Also, the measuring unit 12 may be connected to the current measuring unit A through the third sensing line SL3. For example, the current measuring unit A may be an ammeter or a shunt resistor capable of measuring the charging current and the discharging current of the battery 11. The measuring unit 12 may measure the charging current of the battery 11 through the third sensing line SL3 to calculate the charge amount. In addition, the measuring unit 12 may measure the discharging current of the battery 11 through the third sensing line SL3 to calculate the discharge amount.

An external device (not shown) may have one end connected to the positive electrode terminal P+ of the battery pack 10 and the other end connected to the negative electrode terminal P- of the battery pack 10. Therefore, the positive electrode terminal of the battery 11, the positive electrode terminal P+ of the battery pack 10, the external device, the negative electrode terminal P- of the battery pack 10, and the negative electrode terminal of the battery 11 may be electrically connected.

For example, the external device may be a charger or a load such as a motor of an electric vehicle that is powered by the battery 11.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

(Explanation of reference signs)

10: battery pack
11: battery
12: measuring unit
100: battery information generating apparatus
110: profile obtaining unit
120: voltage comparing unit
130: measurement value determining unit
140: diagnostic resistance determining unit
150: storage unit

**Claims**

1. A battery information generating method, comprising:

   a profile obtaining step (S100) of obtaining a differential profile (DP) representing a correspondence relationship between a voltage and a differential capacity of a battery (11);
   a peak detecting step (S200) of detecting a peak (pk1-pk5) in the differential profile (DP); and
   a voltage comparing step (S300) of comparing a peak voltage corresponding to the peak (pk1-pk5) with a preset reference voltage;
   **characterized by**
   a resistance determining step (S400) of determining a resistance as a measured resistance while discharging the battery (11), the determination being performed within a predetermined time period from a discharge start point of the battery (11), and
   a diagnostic resistance determining step (S500) of determining a diagnostic resistance of the battery (11) based on the measured resistance according to a comparison result of the voltage comparing step (S300).

2. The battery information generating method according to claim 1,
   wherein the diagnostic resistance determining step (S500) includes a step of determining the measured resistance as the diagnostic resistance when the peak voltage is less than the reference voltage.

3. The battery information generating method according to claim 1 or 2,
   wherein the resistance determining step (S400) further includes a voltage determining step (S410) of determining the voltage of the discharge start point as a measured voltage when the peak voltage is greater than or equal to the reference voltage.

4. The battery information generating method according to claim 3,
   wherein the diagnostic resistance determining step (S500) includes:

   a measured resistance correcting step (S510) of correcting the measured resistance based on the measured voltage, the peak voltage and a preset resistance profile (RP); and
   a step (S530) of determining the corrected measured resistance as the diagnostic resistance,

wherein the resistance profile (RP) is a profile that is preset to correspond to the battery (11) and represents a correspondence relationship between the voltage and a resistance.

5. The battery information generating method according to claim 4,
   wherein the measured resistance correcting step (S510) includes:

   a step (S511) of calculating a first value based on the measured voltage and a target voltage;
   a step (S512) of calculating a second value based on the target voltage and the resistance profile (RP);
   a step (S513) of calculating a third value based on the first value and the second value; and
   a step (S514) of calculating the corrected measured resistance based on the third value and the measured resistance,
   wherein the target voltage is determined as a voltage that is greater than or equal to the reference voltage among the peak voltages.

6. The battery information generating method according to claim 5,
   wherein the first value is a difference between the measured voltage and the target voltage.

7. The battery information generating method according to claim 5 or 6,

   wherein the second value is a rate of change of the resistance for the voltage in a target voltage section of the resistance profile (RP), and
   wherein the target voltage section is a voltage section greater than or equal to the target voltage.

8. The battery information generating method according to one of claims 5 to 7,
   wherein the third value is a value obtained by multiplying the first value by the second value.

9. The battery information generating method according to one of claims 5 to 7,
   wherein the corrected measured resistance is a value obtained by adding the third value to the measured resistance.

10. A battery information generating apparatus, comprising:

    a profile obtaining unit (110) configured to obtain a differential profile (DP) representing a correspondence relationship between a voltage and a differential capacity of a battery (11); and
    a voltage comparing unit (120) configured to detect a peak (pk1-pk5) in the differential profile (DP) and compare a peak voltage corresponding to the peak (pk1-pk5) with a preset reference voltage;
    **characterized by**
    a measurement value determining unit (130) configured to determine a resistance for a predetermined time from a discharge start point as a measured resistance by discharging the battery (11), and
    a diagnostic resistance determining unit (140) of configured to determine a diagnostic resistance of the battery based on the measured resistance according to a comparison result.

11. The battery information generating apparatus according to claim 10,
    wherein the diagnostic resistance determining unit (140) is configured to determine the measured resistance as the diagnostic resistance when the peak voltage is less than the reference voltage.

12. The battery information generating apparatus according to claim 10 or 11,
    wherein the measurement value determining unit (130) is configured to determine the voltage of the discharge start point as a measured voltage when the peak voltage is greater than or equal to the reference voltage.

13. The battery information generating apparatus according to claim 12,

    wherein the diagnostic resistance determining unit (140) is configured to correct the measured resistance based on the measured voltage, the peak voltage and a preset resistance profile (RP), and determine the corrected measured resistance as the diagnostic resistance, and
    wherein the resistance profile (RP) is a profile that is preset to correspond to the battery and represents a correspondence relationship between the voltage and a resistance.

14. The battery information generating apparatus according to claim 13,

wherein the diagnostic resistance determining unit (140) is configured to calculate a first value based on the measured voltage and a target voltage, calculate a second value based on the target voltage and the resistance profile (RP); calculate a third value based on the first value and the second value, and calculate the corrected measured resistance based on the third value and the measured resistance, and

wherein the target voltage is determined as a voltage that is greater than or equal to the reference voltage among the peak voltages.

15. A battery pack (10), comprising the battery information generating apparatus according to any one of claims 10 to 14.

**Patentansprüche**

1. Batterieinformationserzeugungsverfahren umfassend:

einen Profilerhaltungsschritt (S100) zum Erhalten eines Differenzprofils (DP), das einen Zusammenhang zwischen einer Spannung und einer Differenzkapazität einer Batterie (11) darstellt;
einen Spitzenwerterfassungsschritt (S200) zum Erfassen eines Spitzenwertes (pk1-pk5) in dem Differenzprofil (DP); und
einen Spannungsvergleichsschritt (S300) zum Vergleichen einer Spitzenwertspannung, die dem Spitzenwert (pk1-pk5) entspricht, mit einer voreingestellten Referenzspannung;
**gekennzeichnet durch**
einen Widerstandsbestimmungsschritt (S400) zum Bestimmen eines Widerstands als einen gemessenen Widerstand während des Entladens der Batterie (11), wobei die Bestimmung innerhalb einer vorbestimmten Zeitdauer ab einem Entladungsstartpunkt der Batterie (11) durchgeführt wird, und
einen Diagnosewiderstandsbestimmungsschritt (S500) zum Bestimmen eines Diagnosewiderstands der Batterie (11) basierend auf dem gemessenen Widerstand gemäß einem Vergleichsergebnis des Spannungsvergleichsschritts (S300).

2. Batterieinformationserzeugungsverfahren nach Anspruch 1,
wobei der Diagnosewiderstandsbestimmungsschritt (S500) einen Schritt zum Bestimmen des gemessenen Widerstands als den Diagnosewiderstand umfasst, wenn die Spitzenwertspannung kleiner als die Referenzspannung ist.

3. Batterieinformationserzeugungsverfahren nach Anspruch 1 oder 2,
wobei der Widerstandsbestimmungsschritt (S400) ferner einen Spannungsbestimmungsschritt (S410) zum Bestimmen der Spannung des Entladungsstartpunkts als eine gemessene Spannung umfasst, wenn die Spitzenwertspannung größer oder gleich der Referenzspannung ist.

4. Batterieinformationserzeugungsverfahren nach Anspruch 3,
wobei der Diagnosewiderstandsbestimmungsschritt (S500) umfasst:

einen Messwiderstandskorrekturschritt (S510) zum Korrigieren des gemessenen Widerstands basierend auf der gemessenen Spannung, der Spitzenwertspannung und einem voreingestellten Widerstandsprofil (RP); und
einen Schritt (S530) zum Bestimmen des korrigierten gemessenen Widerstands als den Diagnosewiderstand, wobei das Widerstandsprofil (RP) ein Profil ist, das voreingestellt ist, um der Batterie (11) zu entsprechen, und einen Zusammenhang zwischen der Spannung und einem Widerstand darstellt.

5. Batterieinformationserzeugungsverfahren nach Anspruch 4,
wobei der Messwiderstandskorrekturschritt (S510) umfasst:

einen Schritt (S511) zum Berechnen eines ersten Werts basierend auf der gemessenen Spannung und einer Zielspannung;
einen Schritt (S512) zum Berechnen eines zweiten Werts basierend auf der Zielspannung und dem Widerstandsprofil (RP);
einen Schritt (S513) zum Berechnen eines dritten Werts basierend auf dem ersten Wert und dem zweiten Wert; und
einen Schritt (S514) zum Berechnen des korrigierten gemessenen Widerstands basierend auf dem dritten Wert und dem gemessenen Widerstand,
wobei die Zielspannung als eine Spannung bestimmt wird, die größer oder gleich der Referenzspannung unter den Spitzenwertspannungen ist.

6. Batterieinformationserzeugungsverfahren nach Anspruch 5,
   wobei der erste Wert eine Differenz zwischen der gemessenen Spannung und der Zielspannung ist.

7. Batterieinformationserzeugungsverfahren nach Anspruch 5 oder 6,

   wobei der zweite Wert eine Änderungsrate des Widerstands für die Spannung in einem Zielspannungsabschnitt des Widerstandsprofils (RP) ist, und
   wobei der Zielspannungsabschnitt ein Spannungsabschnitt ist, der größer oder gleich der Zielspannung ist.

8. Batterieinformationserzeugungsverfahren nach einem der Ansprüche 5 bis 7,
   wobei der dritte Wert ein Wert ist, der durch Multiplizieren des ersten Werts mit dem zweiten Wert erhalten wird.

9. Batterieinformationserzeugungsverfahren nach einem der Ansprüche 5 bis 7,
   wobei der korrigierte gemessene Widerstand ein Wert ist, der durch Addieren des dritten Werts zu dem gemessenen Widerstand erhalten wird.

10. Batterieinformationserzeugungsvorrichtung aufweisend:

    eine Profilerhaltungseinheit (110), die konfiguriert ist, um ein Differenzprofil (DP) zu erhalten, das einen Zusammenhang zwischen einer Spannung und einer Differenzkapazität einer Batterie (11) darstellt; und
    eine Spannungsvergleichseinheit (120), die konfiguriert ist, einen Spitzenwert (pk1-pk5) in dem Differenzprofil (DP) zu erfassen und eine Spitzenwertspannung, die dem Spitzenwert (pk1-pk5) entspricht, mit einer voreingestellten Referenzspannung zu vergleichen;
    **gekennzeichnet durch**
    eine Messwertbestimmungseinheit (130), die konfiguriert ist, um einen Widerstand für eine vorbestimmte Zeit ab einem Entladungsstartpunkt als einen gemessenen Widerstand durch Entladen der Batterie (11) zu bestimmen, und
    eine Diagnosewiderstandsbestimmungseinheit (140), die konfiguriert ist, um einen Diagnosewiderstand der Batterie basierend auf dem gemessenen Widerstand gemäß einem Vergleichsergebnis zu bestimmen.

11. Batterieinformationserzeugungsvorrichtung nach Anspruch 10,
    wobei die Diagnosewiderstandsbestimmungseinheit (140) konfiguriert ist, den gemessenen Widerstand als den Diagnosewiderstand zu bestimmen, wenn die Spitzenwertspannung kleiner als die Referenzspannung ist.

12. Batterieinformationserzeugungsvorrichtung nach Anspruch 10 oder 11,
    wobei die Messwertbestimmungseinheit (130) konfiguriert ist, die Spannung des Entladungsstartpunkts als eine gemessene Spannung zu bestimmen, wenn die Spitzenwertspannung größer oder gleich der Referenzspannung ist.

13. Batterieinformationserzeugungsvorrichtung nach Anspruch 12,

    wobei die Diagnosewiderstandsbestimmungseinheit (140) konfiguriert ist, den gemessenen Widerstand basierend auf der gemessenen Spannung, der Spitzenwertspannung und einem voreingestellten Widerstandsprofil (RP) zu korrigieren und den korrigierten gemessenen Widerstand als den Diagnosewiderstand zu bestimmen, und
    wobei das Widerstandsprofil (RP) ein Profil ist, das voreingestellt ist, um der Batterie zu entsprechen, und einen Zusammenhang zwischen der Spannung und einem Widerstand darstellt.

14. Batterieinformationserzeugungsvorrichtung nach Anspruch 13,

    wobei die Diagnosewiderstandsbestimmungseinheit (140) konfiguriert ist, um einen ersten Wert basierend auf der gemessenen Spannung und einer Zielspannung zu berechnen, einen zweiten Wert basierend auf der Zielspannung und dem Widerstandsprofil (RP) zu berechnen; einen dritten Wert basierend auf dem ersten Wert und dem zweiten Wert zu berechnen und den korrigierten gemessenen Widerstand basierend auf dem dritten Wert und dem gemessenen Widerstand zu berechnen, und
    wobei die Zielspannung als eine Spannung bestimmt wird, die größer oder gleich der Referenzspannung unter den Spitzenwertspannungen ist.

**15.** Batteriepack (10) aufweisend die Batterieinformationserzeugungsvorrichtung nach einem der Ansprüche 10 bis 14.

**Revendications**

**1.** Procédé de génération d'informations de batterie, comportant :

une étape d'obtention de profil (S100) consistant à obtenir un profil DP (differential profile - profil différentiel) représentant une relation de correspondance entre une tension et une capacité différentielle d'une batterie (11) ;
une étape de détection de crête (S200) consistant à détecter une crête (pk1 à pk5) dans le profil DP (differential profile - profil différentiel) ; et
une étape de comparaison de tension (S300) consistant à comparer une tension de crête correspondant à la crête (pk1 à pk5) avec une tension de référence préétablie ;
**caractérisé par**
une étape de détermination de résistance (S400) consistant à déterminer une résistance comme étant une résistance mesurée tout en déchargeant la batterie (11), la détermination étant effectuée dans les limites d'une période de temps prédéterminée à partir d'un point de départ de décharge de la batterie (11), et
une étape de détermination de résistance de diagnostic (S500) consistant à déterminer une résistance de diagnostic de la batterie (11) sur la base de la résistance mesurée en fonction d'un résultat de comparaison de l'étape de comparaison de tension (S300).

**2.** Procédé de génération d'informations de batterie selon la revendication 1,
dans lequel l'étape de détermination de résistance de diagnostic (S500) comprend une étape consistant à déterminer la résistance mesurée comme étant la résistance de diagnostic quand la tension de crête est inférieure à la tension de référence.

**3.** Procédé de génération d'informations de batterie selon la revendication 1 ou la revendication 2,
dans lequel l'étape de détermination de résistance (S400) comprend par ailleurs une étape de détermination de tension (S410) consistant à déterminer la tension du point de départ de décharge comme étant une tension mesurée quand la tension de crête est supérieure ou égale à la tension de référence.

**4.** Procédé de génération d'informations de batterie selon la revendication 3,
dans lequel l'étape de détermination de résistance de diagnostic (S500) comprend :

une étape de correction de résistance mesurée (S510) consistant à corriger la résistance mesurée sur la base de la tension mesurée, de la tension de crête et d'un profil RP (resistance profile - profil de résistance) préétabli ; et
une étape (S530) consistant à déterminer la résistance mesurée corrigée comme étant la résistance de diagnostic,
dans lequel le profil RP (resistance profile - profil de résistance) est un profil qui est préétabli pour correspondre à la batterie (11) et qui représente une relation de correspondance entre la tension et une résistance.

**5.** Procédé de génération d'informations de batterie selon la revendication 4,
dans lequel l'étape de correction de résistance mesurée (S510) comprend :

une étape (S511) consistant à calculer une première valeur sur la base de la tension mesurée et d'une tension cible ;
une étape (S512) consistant à calculer une deuxième valeur sur la base de la tension cible et du profil RP (resistance profile - profil de résistance) ;
une étape (S513) consistant à calculer une troisième valeur sur la base de la première valeur et de la deuxième valeur ; et
une étape (S514) consistant à calculer la résistance mesurée corrigée sur la base de la troisième valeur et de la résistance mesurée,
dans lequel la tension cible est déterminée comme étant une tension qui est supérieure ou égale à la tension de référence parmi les tensions de crête.

**6.** Procédé de génération d'informations de batterie selon la revendication 5,
dans lequel la première valeur est une différence entre la tension mesurée et la tension cible.

**7.** Procédé de génération d'informations de batterie selon la revendication 5 ou la revendication 6,

dans lequel la deuxième valeur est un taux de changement de la résistance pour la tension dans une section de tension cible du profil RP (resistance profile - profil de résistance), et

dans lequel la section de tension cible est une section de tension supérieure ou égale à la tension cible.

**8.** Procédé de génération d'informations de batterie selon l'une des revendications 5 à 7,
dans lequel la troisième valeur est une valeur obtenue en multipliant la première valeur par la deuxième valeur.

**9.** Procédé de génération d'informations de batterie selon l'une des revendications 5 à 7,
dans lequel la résistance mesurée corrigée est une valeur obtenue en ajoutant la troisième valeur à la résistance mesurée.

**10.** Appareil de génération d'informations de batterie, comportant :

une unité d'obtention de profil (110) configurée pour obtenir un profil DP (differential profile - profil différentiel) représentant une relation de correspondance entre une tension et une capacité différentielle d'une batterie (11) ; et

une unité de comparaison de tension (120) configurée pour détecter une crête (pk1 à pk5) dans le profil DP (differential profile - profil différentiel) et pour comparer une tension de crête correspondant à la crête (pk1 à pk5) avec une tension de référence préétablie ;
**caractérisé par**
une unité de détermination de valeur de mesure (130) configurée pour déterminer une résistance pendant une période de temps prédéterminée à partir d'un point de départ de décharge comme étant une résistance mesurée tout en déchargeant la batterie (11), et

une unité de détermination de résistance de diagnostic (140) configurée pour déterminer une résistance de diagnostic de la batterie sur la base de la résistance mesurée en fonction d'un résultat de comparaison.

**11.** Appareil de génération d'informations de batterie selon la revendication 10,
dans lequel l'unité de détermination de résistance de diagnostic (140) est configurée pour déterminer la résistance mesurée comme étant la résistance de diagnostic quand la tension de crête est inférieure à la tension de référence.

**12.** Appareil de génération d'informations de batterie selon la revendication 10 ou la revendication 11,
dans lequel l'unité de détermination de valeur de mesure (130) est configurée pour déterminer la tension du point de départ de décharge comme étant une tension mesurée quand la tension de crête est supérieure ou égale à la tension de référence.

**13.** Appareil de génération d'informations de batterie selon la revendication 12,

dans lequel l'unité de détermination de résistance de diagnostic (140) est configurée pour corriger la résistance mesurée sur la base de la tension mesurée, de la tension de crête et d'un profil RP (resistance profile - profil de résistance) préétabli, et pour déterminer la résistance mesurée corrigée comme étant la résistance de diagnostic, et

dans lequel le profil RP (resistance profile - profil de résistance) est un profil qui est préétabli pour correspondre à la batterie et qui représente une relation de correspondance entre la tension et une résistance.

**14.** Appareil de génération d'informations de batterie selon la revendication 13,

dans lequel l'unité de détermination de résistance de diagnostic (140) est configurée pour calculer une première valeur sur la base de la tension mesurée et d'une tension cible, pour calculer une deuxième valeur sur la base de la tension cible et du profil RP (resistance profile - profil de résistance) ; pour calculer une troisième valeur sur la base de la première valeur et de la deuxième valeur, et pour calculer la résistance mesurée corrigée sur la base de la troisième valeur et de la résistance mesurée, et

dans lequel la tension cible est déterminée comme étant une tension qui est supérieure ou égale à la tension de référence parmi les tensions de crête.

**15.** Bloc de batterie (10), comportant l'appareil de génération d'informations de batterie selon l'une quelconque des revendications 10 à 14.

FIG. 1

```
            ┌─────────┐
            │  START  │
            └─────────┘
                 │
                 ▼              ╭S100
    ┌────────────────────────────────┐
    │     PROFILE OBTAINING STEP     │
    └────────────────────────────────┘
                 │
                 ▼              ╭S200
    ┌────────────────────────────────┐
    │       PEAK DETECTING STEP      │
    └────────────────────────────────┘
                 │
                 ▼              ╭S300
    ┌────────────────────────────────┐
    │     VOLTAGE COMPARING STEP     │
    └────────────────────────────────┘
                 │
                 ▼              ╭S400
    ┌────────────────────────────────┐
    │   RESISTANCE DETERMINING STEP  │
    └────────────────────────────────┘
                 │
                 ▼              ╭S500
    ┌──────────────────────────────────────┐
    │ DIAGNOSTIC RESISTANCE DETERMINING STEP│
    └──────────────────────────────────────┘
                 │
                 ▼
            ┌─────────┐
            │   END   │
            └─────────┘
```

FIG. 2

100

BATTERY INFORMATION
GENERATING APPARATUS

110

PROFILE OBTAINING UNIT

120

VOLTAGE COMPARING UNIT

130

MEASUREMENT VALUE
DETERMINING UNIT

140

DIAGNOSTIC RESISTANCE
DETERMINING UNIT

150

STORAGE UNIT

FIG. 3

S200

S300

IS PEAK VOLTAGE GREATER THAN OR EQUAL TO REFERENCE VOLTAGE?

NO

YES

S400

S410

VOLTAGE DETERMINING STEP

S420

RESISTANCE DETERMINING STEP

S430

RESISTANCE DETERMINING STEP

S510

STEP FOR CORRECTING MEASURED RESISTANCE

S530

STEP FOR DETERMINING CORRECTED MEASURED RESISTANCE AS DIAGNOSTIC RESISTANCE

S520

STEP FOR DETERMINING MEASURED RESISTANCE AS DIAGNOSTIC RESISTANCE

S500

END

FIG. 4

S420

S510

S511
FIRST VALUE CALCULATING STEP

S512
SECOND VALUE CALCULATING STEP

S513
THIRD VALUE CALCULATING STEP

S514
CORRECTING THE MEASURED RESISTANCE

S520

FIG. 5

FIG. 6

FIG. 7

## REFERENCES CITED IN THE DESCRIPTION

**Patent documents cited in the description**

- KR 1020240022912
- US 2012169288 A1
- KR 102600139 B1